# EUROPEAN PATENT APPLICATION

(11) **EP 4 845 328 A1**
(43) Date of publication of application: **25.11.2026**
(21) Application number: 25226654.9
(22) Date of filing: 23.12.2025
(51) Int. Cl.: H10B 12/00, H10D 30/67, H10W 20/00

(54) **SEMICONDUCTOR DEVICE AND METHOD FOR FABRICATING THE SAME**

(30) Priority: 19.05.2025 KR 20250064381
(71) Applicant: SK hynix Inc., Bubal-eub Icheon-si Gyeonggi-do 17336 (KR)
(72) Inventor: KIM, Beomyoung, 17336 Icheon-si, Gyeonggi-do (KR); RYU, Kyung Sun, 17336 Icheon-si, Gyeonggi-do (KR); BAE, Gi Yoon, 17336 Icheon-si, Gyeonggi-do (KR)
(74) Representative: Isarpatent

(57) **Abstract**

A semiconductor device includes: a plurality of semiconductor pillars; main gates respectively disposed to cover one sidewall of each of the plurality of semiconductor pillars; bit lines respectively coupled to the plurality of semiconductor pillars; shielding layers disposed between the bit lines; and air gaps disposed between the shielding layers and the bit lines.

## Description

### BACKGROUND

### 1. Field

Exemplary embodiments of the present disclosure relate to a semiconductor device, and more particularly, to a semiconductor device including a vertical gate structure, and a method for fabricating a semiconductor device.

### 2. Description of the Related Art

The degree of integration of a semiconductor device refers to the number of transistors or other components that can be fabricated on a single chip. This provides a measure of how much functionality is packed into a given area of silicon. As semiconductor devices become more highly integrated, the distance between neighboring conductive structures becomes increasingly closer. This may increase the parasitic capacitance. The increase in the parasitic capacitance may deteriorate the performance of the semiconductor devices.

### SUMMARY

Embodiments of the present disclosure are directed to a semiconductor device capable of suppressing parasitic capacitance between conductive structures, and a method for fabricating the semiconductor device.

In accordance with an embodiment of the present disclosure, a method for fabricating a semiconductor device includes: forming a semiconductor pillar; forming a bit line over the semiconductor pillar; forming a sacrificial spacer on a sidewall of the bit line; forming a shielding layer disposed on the sacrificial spacer; and forming an air gap between the shielding layer and the bit lines by removing the sacrificial spacer.

In accordance with another embodiment of the present disclosure, a semiconductor device includes: a plurality of semiconductor pillars; main gates respectively disposed to cover one sidewall of each of the plurality of semiconductor pillars; bit lines respectively coupled to the plurality of semiconductor pillars; shielding layers disposed between the bit lines; and air gaps disposed between the shielding layers and the bit lines.

### BRIEF DESCRIPTION OF THE DRAWINGS

FIG. 1 is a schematic perspective view illustrating a semiconductor device in accordance with an embodiment of the present disclosure.
FIG. 2 is a schematic plan view illustrating a semiconductor device in accordance with the embodiment of the present disclosure.
FIG. 3A is a cross-sectional view illustrating the semiconductor device in accordance with the embodiment of the present disclosure.
FIG. 3B is a cross-sectional view of the semiconductor device taken along a line A-A' shown in FIG. 2.
FIG. 3C is a cross-sectional view of the semiconductor device taken along a line B-B' shown in FIG. 2.
FIG. 4A is a cross-sectional view illustrating a semiconductor device in accordance with another embodiment of the present disclosure.
FIG. 4B is a cross-sectional view of the semiconductor device taken along the line A-A' shown in FIG. 2 in accordance with the embodiment of the present disclosure.
FIG. 4C is a cross-sectional view of the semiconductor device taken along the line B-B' shown in FIG. 2 in accordance with the embodiment of the present disclosure.
FIGS. 5A to 16 illustrate an example of a method for fabricating a semiconductor device in accordance with an embodiment of the present disclosure.
FIG. 17 illustrates a semiconductor device in accordance with another embodiment of the present disclosure.
FIGS. 18 to 20 illustrate an example of a method for fabricating a semiconductor device in accordance with another embodiment of the present disclosure.

### DETAILED DESCRIPTION

Exemplary embodiments of the present disclosure will be described below in more detail with reference to the accompanying drawings. The present disclosure may, however, be embodied in different forms and should not be construed as limited to the embodiments set forth herein. Rather, these embodiments are provided so that this disclosure will be thorough and complete, and will fully convey the scope of the present disclosure to those skilled in the art. Throughout the disclosure, like reference numerals refer to like parts throughout the various figures and embodiments of the present disclosure.

Hereinafter, the various embodiments of the present disclosure will be described in detail with reference to the attached drawings.

The drawings are not necessarily to scale and in some instances, proportions may have been exaggerated in order to clearly illustrate features of the embodiments. When a first layer is referred to as being "on" a second layer or "on" a substrate, it not only refers to a case where the first layer is formed directly on the second layer or the substrate but also a case where a third layer exists between the first layer and the second layer or the substrate.

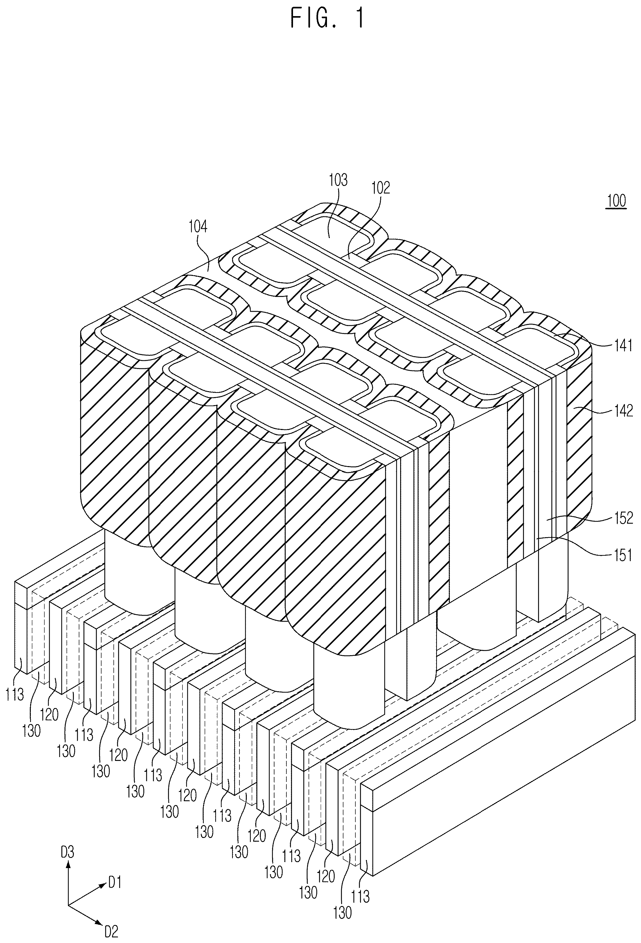

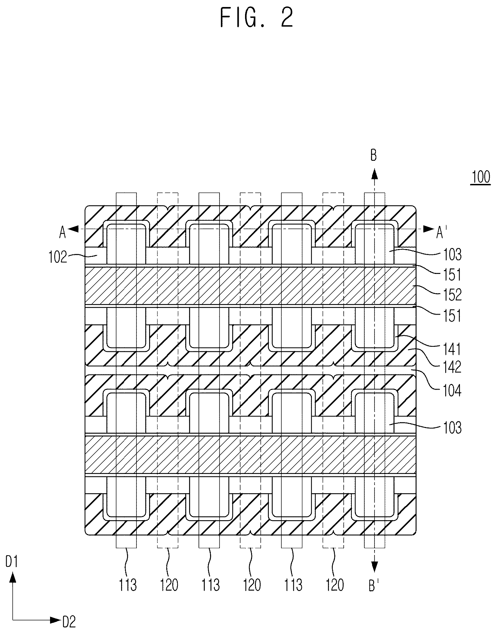

FIG. 1 is a schematic perspective view illustrating a semiconductor device in accordance with an embodiment of the present disclosure. FIG. 2 is a schematic plan view illustrating a semiconductor device in accordance with the embodiment of the present disclosure.

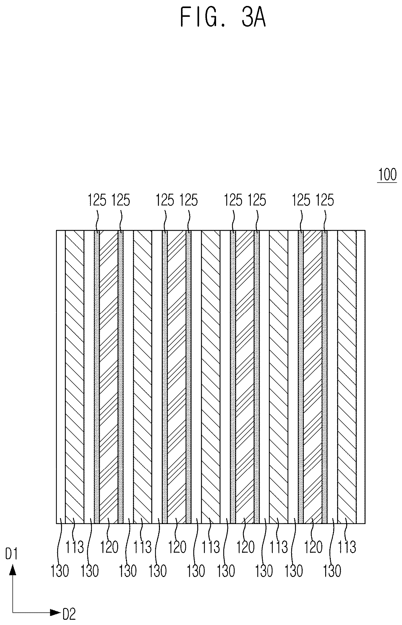

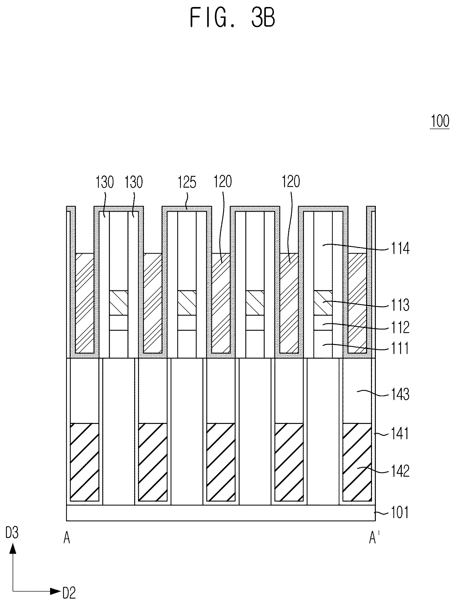

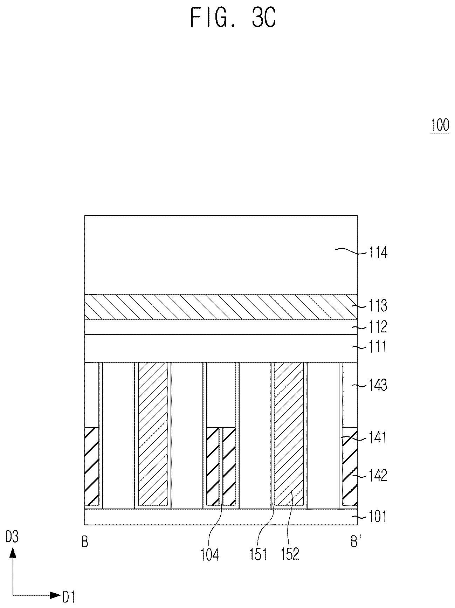

FIG. 3A is a cross-sectional view illustrating the semiconductor device in accordance with the embodiment of the present disclosure. FIG. 3B is a cross-sectional view of the semiconductor device taken along a line A-A' shown in FIG. 2. FIG. 3C is a cross-sectional view of the semiconductor device taken along a line B-B' shown in FIG. 2.

Referring to FIGS. 1 to 3C, the semiconductor device 100 may include a plurality of dielectric pillars 102, a plurality of semiconductor pillars 103, main gates 142 each of which covers one sidewall of each of the semiconductor pillars 103, bit lines 113 respectively coupled to the semiconductor pillars 103, shielding layers 120 each of which is disposed between the bit lines 113, and air gaps 130 disposed between the shielding layers 120 and the neighboring bit lines 113.

The bit lines 113 may extend in a first direction D1, and the main gates 142 may extend in a second direction D2, and the semiconductor pillars 103 may extend in a third direction D3. The first to third directions may intersect with each other.

Referring back to FIG. 1, the semiconductor device 100 may include main gates 142 each of which is disposed between the semiconductor pillars 103 and covers one sidewall of each of the semiconductor pillars 103, at least one or more bit lines 113 respectively coupled to the semiconductor pillars 103 and spaced apart from each other in a direction perpendicular to the direction that the semiconductor pillars 103 extend, shielding layers 120 respectively disposed between the bit lines 113, and air gaps 130 disposed between the shielding layers 120 and the neighboring bit lines 113. The semiconductor device 100 may further include a back gate 152.

Referring to FIG. 2, from the perspective of a top view, the semiconductor pillars 103 may have a form of a matrix in which the semiconductor pillars 103 are spaced apart from each other by a predetermined interval in the first direction D1 and the second direction D2 which is perpendicular to the first direction D1.

The semiconductor pillars 103 may be formed to cover a portion of three consecutive sidewalls with the main gate 142 and to extend in a vertical direction over the substrate.

The semiconductor pillars 103 may be formed of a material suitable for semiconductor processing. The semiconductor pillars 103 may be formed of a material containing silicon. The semiconductor pillars 103 may include silicon, monocrystalline silicon, polysilicon, and amorphous silicon. The semiconductor pillars 103 may also include other semiconductor materials, such as germanium.

According to another embodiment of the present disclosure, the semiconductor pillars 103 may include an oxide semiconductor material. For example, the oxide semiconductor material may include IGZO (Indium Gallium Zinc Oxide), InSnZnO, ZnSnO, or a combination thereof. According to another embodiment of the present disclosure, the semiconductor pillars 103 may include a conductive metal oxide. According to another embodiment of the present disclosure, the semiconductor pillars 103 may include a two-dimensional material, for example, molybdenum disulfide (MoS₂), tungsten disulfide (WS₂), or molybdenum diselenide (MoSe₂).

The semiconductor pillars 103 may include a III/V-group semiconductor substrate, for example, a compound semiconductor substrate such as gallium arsenide (GaAs). The semiconductor pillars 103 may include an SOI (Silicon-On-Insulator) substrate.

The main gate 142 may correspond to a word line. The main gate 142 may be a vertical word line. The main gate 142 may surround a portion of the sidewall of the semiconductor pillar 103.

Referring to FIGS. 1 and 2, the main gate 142 may be disposed on a portion of the sidewall between the semiconductor pillars 103. The main gate 142 may have a shape that surrounds a portion of the sidewall of the semiconductor pillar 103 having a square shape with round corners.

The main gate 142 may be disposed between the semiconductor pillars 103.

The main gate 142 may include a metal-based material. The main gate 142 may include a metal, a metal nitride, or a combination thereof. The main gate 142 may include tantalum nitride (TaN), titanium nitride (TiN), tungsten (W), tungsten nitride (WN), or a combination thereof. A gate dielectric layer 141 may be formed between the main gate 142 and the semiconductor pillar 103.

One sidewall of the semiconductor pillar 103 that does not contact the main gate 142 may contact the back gate 152. The semiconductor pillars 103 on both sides of the back gate 152 may be symmetrically covered by the main gates 142.

The gate dielectric layer 141 may be interposed between the semiconductor pillar 103 and the main gate 142, and a back gate dielectric layer 151 may be interposed between the semiconductor pillar 103 and the back gate 152.

The gate dielectric layer 141 may be formed to cover a portion of the sidewall of the semiconductor pillar 103. The gate dielectric layer 141 may be formed to surround at least a portion of three consecutive sidewalls excluding the sidewall that is covered by the back gate dielectric layer 151.

The gate dielectric layer 141 may be formed along the sidewall of the semiconductor pillar 103 having a shape with round corners.

The main gate 142 may be formed along the sidewall of the semiconductor pillar 103 with a uniform width. The main gate 142 may be formed over the gate dielectric layer 141 to cover the semiconductor pillar 103 in a square shape with round corners along the semiconductor pillar 103. The main gates 142 may extend in the second direction D2 to be integrated with each other while surrounding the sidewalls of the semiconductor pillars 103 disposed adjacent to the main gates 142.

A gate capping layer 143 may be formed in the remaining portion where the main gate 142 is formed to have the same height as that of the semiconductor pillar 130. The gate capping layer 143 may be formed to surround the remaining portion of the semiconductor pillar 130 that is left after the semiconductor pillar 130 is surrounded by the main gate 142. The gate capping layer 143 may be formed to have the same height as that of the semiconductor pillar 130.

A dielectric material 104 may fill between the main gates 142 that are formed to surround the neighboring semiconductor pillars 103.

The bit line structure may include a bit line contact node 111, a bit line barrier 112, a bit line 113, and a bit line hard mask 114 that are stacked in the mentioned order. From the perspective of a top view, the bit line structure may be a line-shaped pattern structure. The bit lines 113 may be spaced apart from each other in the second direction D2 and may extend in the first direction D1.

The bit lines 113 may be formed to be respectively coupled to the semiconductor pillars 103 on one side from which the semiconductor pillars 103 extend. The bit lines 113 may be spaced apart from each other in a direction perpendicular to the direction that the semiconductor pillars 103 extend.

The bit lines 113 may include a metal-based material. The bit lines 113 may include a metal, a metal nitride, a metal silicide, or a combination thereof. The bit lines 113 may include a tungsten layer.

The main gate 142 and the bit lines 113 may extend in directions intersecting with each other. The main gate 142 and the bit lines 113 may be vertically spaced apart from each other.

FIGS. 3A to 3C are cross-sectional views of a semiconductor device in accordance with an embodiment of the present disclosure.

Referring to FIG. 3A, an air gap 130, an air gap spacer 125, a shielding layer 120, an air gap spacer 125, and an air gap 130 may be sequentially formed between the bit lines 113 of the semiconductor device 100.

The shielding layer 120 may extend in the first direction D1 in the same manner as the bit lines 113 do. The shielding layer 120 may be disposed between the bit lines 113 that are spaced apart from each other in the second direction D2.

The shielding layer 120 in the third direction D3 may be formed to have a height which is higher than that of the bit lines 113. The bit line 113 and the shielding layer 120 may be spaced apart from each other by a uniform distance in the second direction D2.

The shielding layer 120 may be formed of a conductive shielding material including an electrically conductive composition.

The air gap 130 may be disposed on both sides of the bit line 113. The air gap 130 may extend parallel to the bit line 113 in the first direction D1.

The air gap 130 may be disposed between the bit line 113 and the shielding layer 120. The air gap 130 may be formed with a uniform thickness along the bit line 113. The air gap 130 may extend in the first direction D1 in the same manner as the direction that the bit line 113 extends.

The air gap 130 may be formed higher than the bit line 113 in the third direction D3. The air gap 130 may be formed to have the same height as that of the bit line structure.

The air gap spacer 125 may be formed to divide the space between the bit lines 113 into a space where the air gap 130 and the shielding layer 120 are to be formed. The air gap spacer 125 may be formed to cover the air gap 130 that is formed on the sidewall of the bit line 113. The air gap spacer 125 may be formed to surround the air gaps 130 on both sides of the bit line 113 and may be formed in an integrated form along the upper surface of the substrate 101 where the semiconductor pillars 103 exposed between the neighboring bit lines 113 are not formed. The air gap spacer 125 may be formed to surround the bit line structure and the air gap 130 in a direction opposite to the direction that the main gate 142 is formed.

The air gap spacer 125 may include a dielectric material, for example, an oxide, a nitride, or a combination thereof. According to another embodiment of the present disclosure, the air gap spacer 125 may include a low-k material. The low-k material may include silicon carbon oxide (SiCO), boron nitride, or a combination thereof.

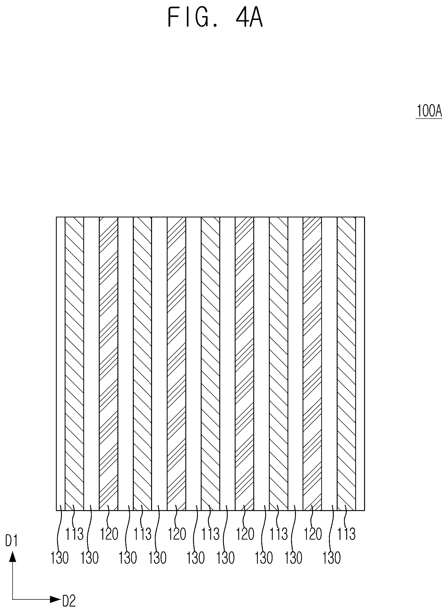

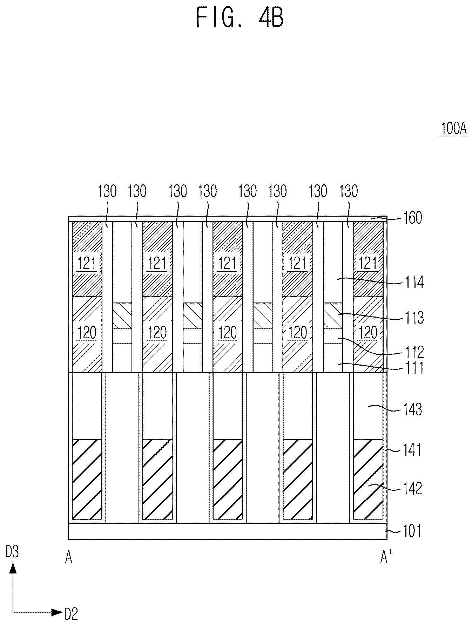

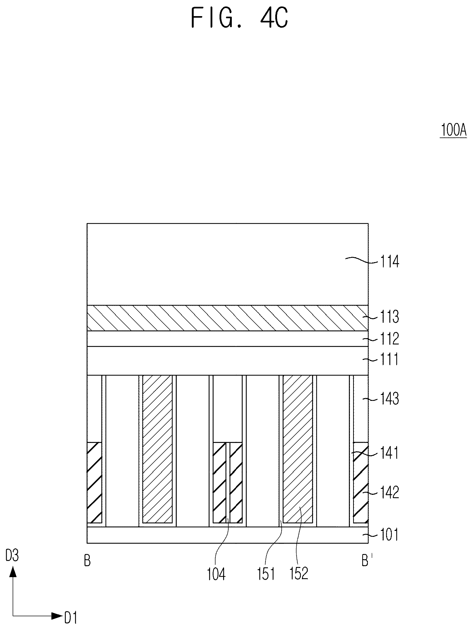

FIG. 4A is a cross-sectional view illustrating a semiconductor device 100A in accordance with another embodiment of the present disclosure. FIG. 4B is a cross-sectional view of the semiconductor device 100A taken along the line A-A' shown in FIG. 2 in accordance with the embodiment of the present disclosure. FIG. 4C is a cross-sectional view of the semiconductor device 100A taken along the line B-B' shown in FIG. 2 in accordance with an embodiment of the present disclosure.

The semiconductor device 100A in accordance with another embodiment of the present disclosure, as illustrated in FIG. 4A, may include a plurality of semiconductor pillars 103, main gates 142 each of which covers one sidewall of each of the semiconductor pillars 103, bit lines 113 respectively coupled to the semiconductor pillars 103, shielding layers 120 disposed between the bit lines 113, and air gaps 130 each of which is disposed between each shielding layer 120 and the neighboring bit lines 113.

The bit lines 113 may extend in the first direction D1, the main gates 142 may extend in the second direction D2, and the semiconductor pillars 103 may extend in the third direction D3. The first to third directions may intersect with each other. The air gaps 130 may be disposed between the bit lines 113 and the shielding layers 120.

The semiconductor device 100A may have an air gap spacer-free structure, and an air gap spacer may not be formed between the shielding layers 120 and the air gaps 130.

The air gap 130 may be disposed on both sides of the bit line 113. The air gap 130 may extend with a uniform thickness in the first direction D1 in the same manner as the bit line 113 does. The air gap 130 may extend parallel to the bit line 113. In the semiconductor device 100A, the air gap 130 and the shielding layer 120 may extend with a uniform thickness along the bit line 113.

Referring to FIG. 4B, a shield capping layer 121 may be further formed in the upper portion of the shielding layer 120.

The shield capping layer 121 may be formed to fill the upper portion of the shielding layer 120 up to the same height as that of the bit line structure. The shield capping layer 121 may include silicon oxide or silicon nitride.

Also, an air gap capping layer 160 may be further formed on the upper surfaces of the shield capping layer 121 and the bit line hard mask 114. The air gaps 130 may be formed by the air gap capping layer 160.

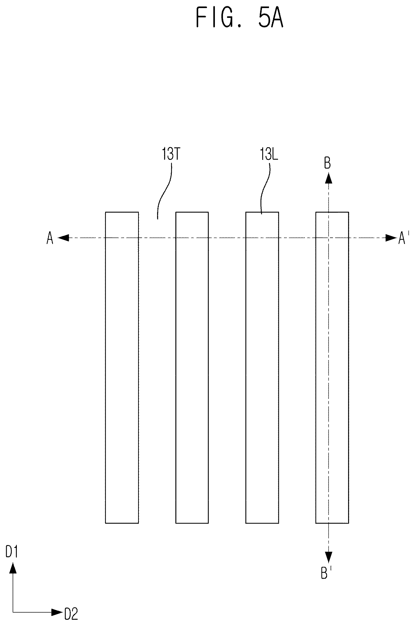

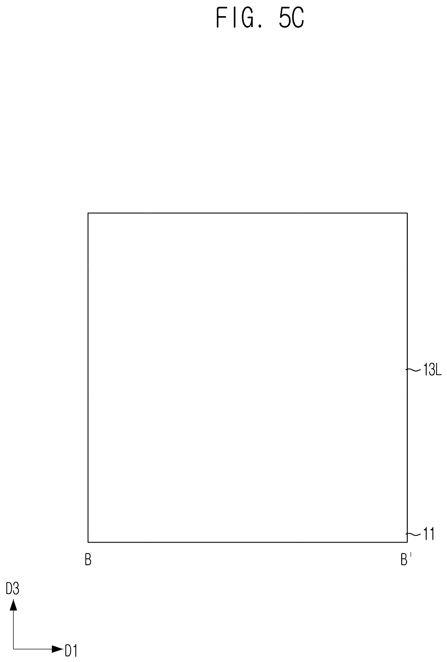

FIGS. 5A to 16 illustrate an example of a method for fabricating a semiconductor device in accordance with an embodiment of the present disclosure.

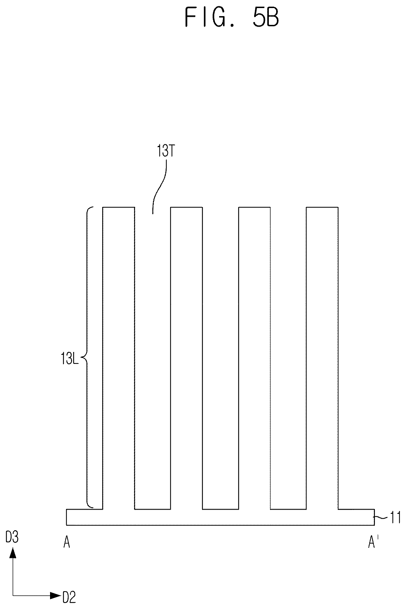

FIGS. 5A, 6A, 7A, 8A, 9A and 10A are plan views illustrating a method for fabricating a semiconductor device. FIGS. 5B, 6B, 7B, 8B, 9B and 10B are cross-sectional views taken along a line A-A' shown in FIGS. 5A, 6A, 7A, 8A, 9A and 10A, and FIGS. 5C, 6C, 7C, 8C, 9C and 10C are cross-sectional views respectively taken along a line B-B' shown in FIGS. 5A, 6A, 7A, 8A, 9A and 10A.

Referring to FIGS. 5A to 5C, line patterns 13L and first trenches 13T may be formed over a substrate 11.

In order to form the line patterns 13L, a hard mask layer (not shown) may be formed in the upper portion of the substrate 11, and the substrate 11 may be etched by using the hard mask layer as a barrier. The line patterns 13L may extend vertically in the third direction D3 and may extend in the first direction D1. The line patterns 13L may be disposed to be spaced apart from each other in the second direction D2.

First trenches 13T may be formed between the line patterns 13L. The bottom surfaces of the first trenches 13T may expose a portion of the substrate 11.

A plurality of line patterns 13L and a plurality of first trenches 13T may be formed by a series of etching processes.

The substrate 11 may be a material suitable for semiconductor processing. The substrate 11 may include a semiconductor material. The substrate 11 may include a semiconductor element, such as silicon (Si) or germanium (Ge), or may include at least one compound semiconductor. The substrate 11 may include a silicon substrate, a silicon germanium (SiGe) substrate, or an SOI (Silicon-On-Insulator) substrate.

The substrate 11 may include silicon, monocrystalline silicon, polysilicon, amorphous silicon, silicon germanium, monocrystalline silicon germanium, polycrystalline silicon germanium, carbon-doped silicon, a combination thereof, or a multi-layer thereof. The substrate 11 may also include a III/V-group semiconductor substrate, for example, a compound semiconductor substrate, such as gallium arsenide (GaAs). An oxide semiconductor channel layer may include an SOI (Silicon-On-Insulator) substrate.

The substrate 11 may include at least one compound semiconductor selected among silicon carbide (SiC), indium arsenide (InAs), and indium phosphide (InP).

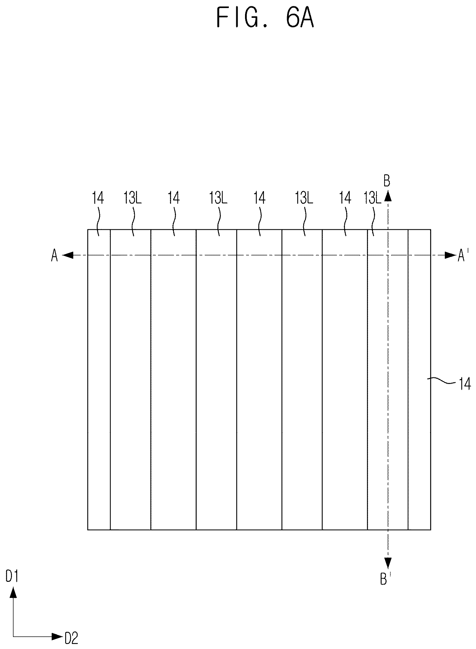

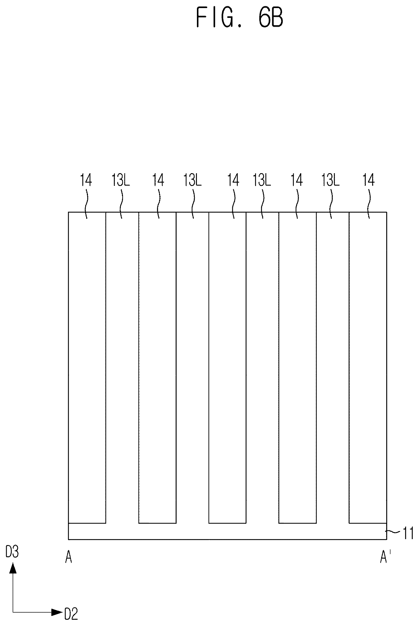

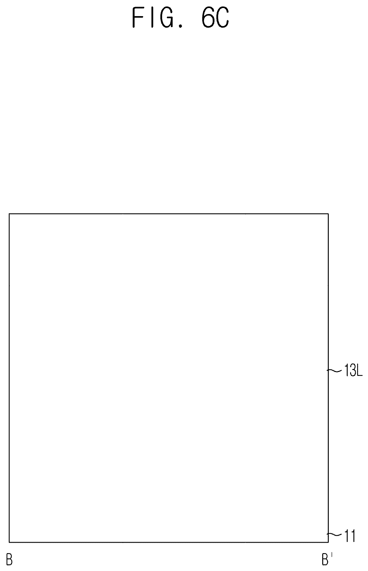

Referring to FIGS. 6A to 6C, dielectric pillars 14 (for example, dielectric lines) may be formed between the line patterns 13L. To form the dielectric pillars 14, a dielectric material may be deposited to fill the first trenches 13T between the line patterns 13L, and then a planarization process of the dielectric material may be performed. The dielectric pillars 14 may fill the first trenches 13T, respectively.

The dielectric pillars 14 may include a dielectric material. For example, the dielectric pillars 14 may include silicon oxide, silicon nitride, silicon carbon oxide (SiCO), a spin-on-dielectric, or a combination thereof. For example, the dielectric pillars 14 may be formed by sequentially forming silicon nitride, silicon carbon oxide, and a spin-on dielectric and then performing a planarization process.

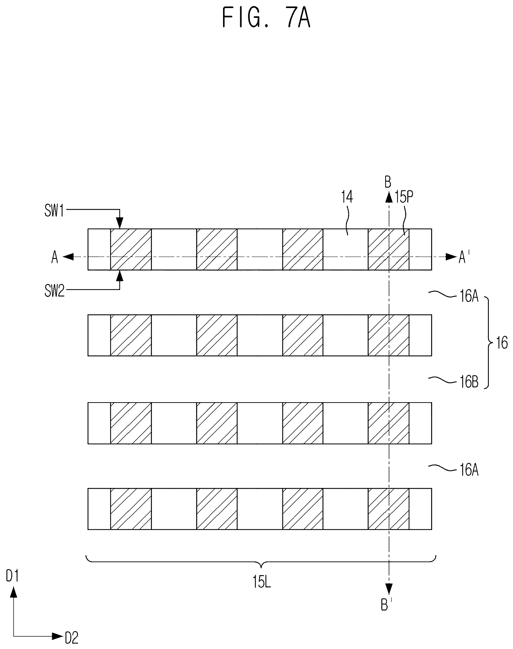

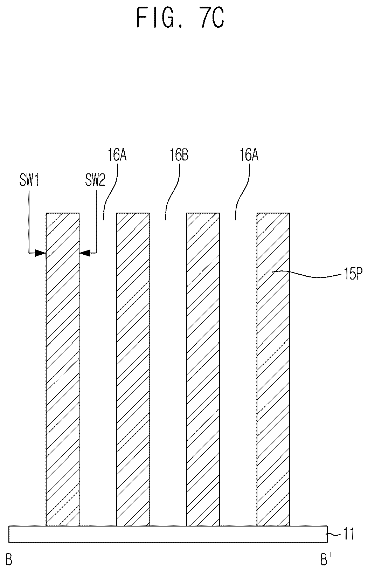

Referring to FIGS. 7A to 7C, a portion of the line patterns 13L may be selectively etched to form semiconductor pillars 15P.

Second trenches 16 may be formed in a vertical direction with respect to the dielectric pillars 14.

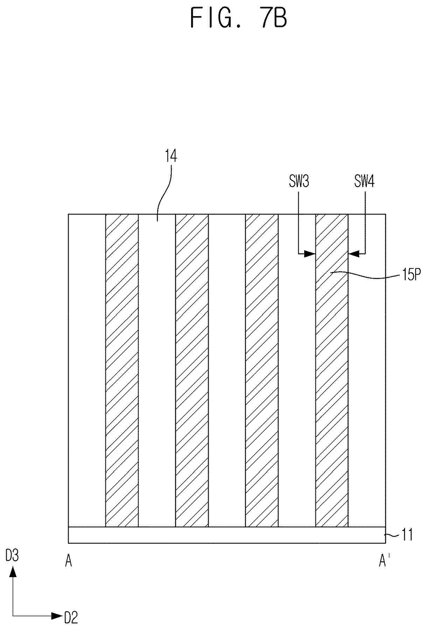

The second trenches 16 may be formed between the semiconductor pillars 15P. The second trenches 16 may expose one side of the substrate 11. The first trenches 13T and the second trenches 16 may intersect with each other vertically. The dielectric pillars 14 may be partially cut by the second trenches 16. Hereinafter, the dielectric pillars 14 that are cut may be simply referred to as dielectric pillars 14. Referring to FIGS. 7A and 7B, the dielectric pillars 14 may be disposed between the semiconductor pillars 15P in the A-A' direction.

The second trenches 16 may include first segments 16A and second segments 16B between the first segments 16A.

Each of the semiconductor pillars 15P may include first to fourth sidewalls SW1 to SW4. The first sidewall SW1 and the second sidewall SW2 of each semiconductor pillar 15P may be exposed by the second trenches 16, and the third sidewall SW3 and the fourth sidewall SW4 of each semiconductor pillar 15P may not be exposed by the dielectric pillars 14.

Consecutive line structures 15L in which semiconductor pillars 15P and the dielectric pillars 14 are alternately disposed may be formed by the non-exposed sidewalls. The line structures 15L may extend in the second direction D2 and may be formed to be spaced apart from each other in the first direction D1.

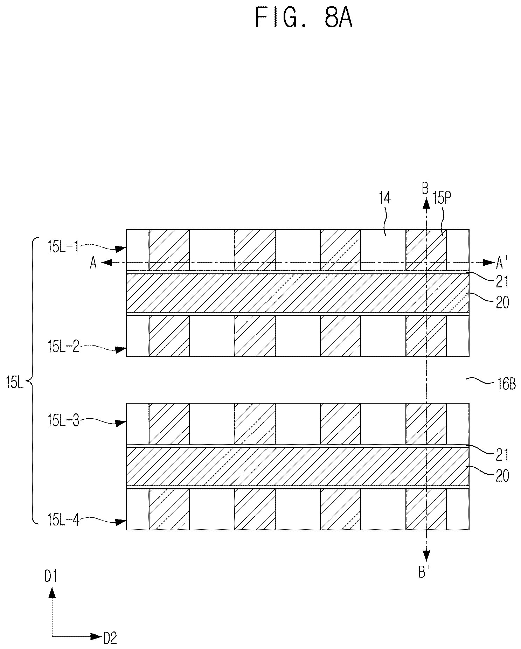

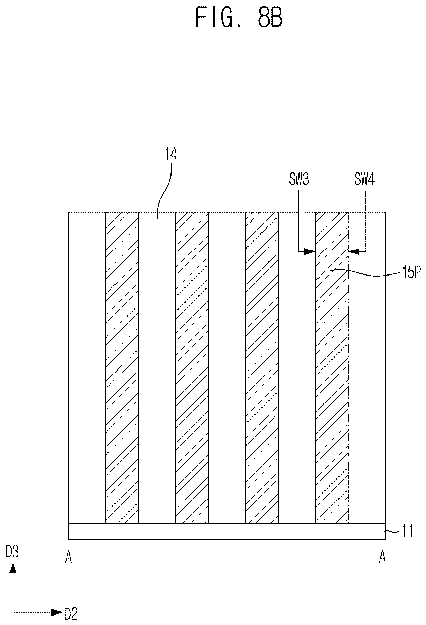

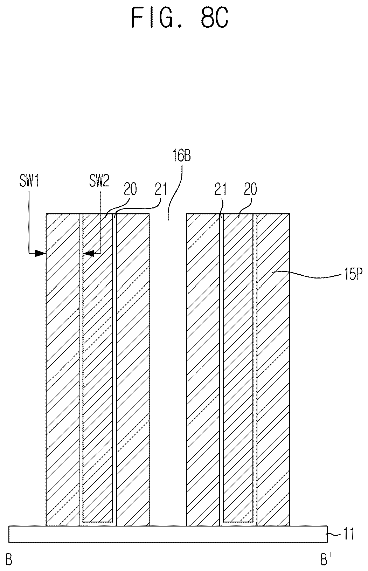

Referring to FIGS. 8A to 8C, a back gate 20 may be formed between the line structures 15L. The back gate 20 may fill the first segments 16A of the second trench 16.

The back gate 20 may be spaced apart from each other in the first direction D1 and may extend in the second direction D2 parallel to the line structures 15L. The back gate 20 may be formed between the line structures 15L of a pair.

The back gate 20 may be formed of a semiconductor material, a metal material, a conductive metal nitride, or a combination thereof.

Back gate dielectric layers 21 may conformally cover a portion of the sidewalls of the line structures 15L. A plurality of back gates 20 may be formed to fill between the line structures 15L while covering the back gate dielectric layers 21. Each of the back gate dielectric layers 21 may extend along each of the two sides of the back gate 20.

The back gate dielectric layer 21 may be formed of at least one selected among silicon oxide, silicon nitride, silicon oxynitride, ONO (oxide/nitride/oxide), and high-k dielectrics whose dielectric constant is greater than that of silicon oxide.

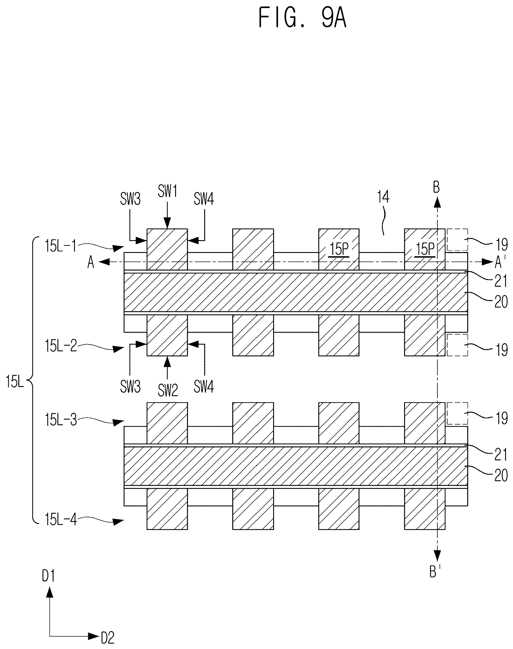

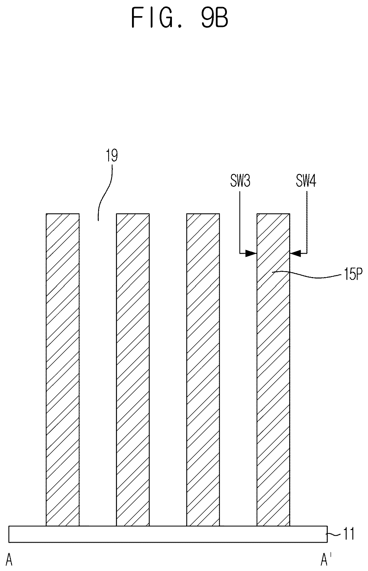

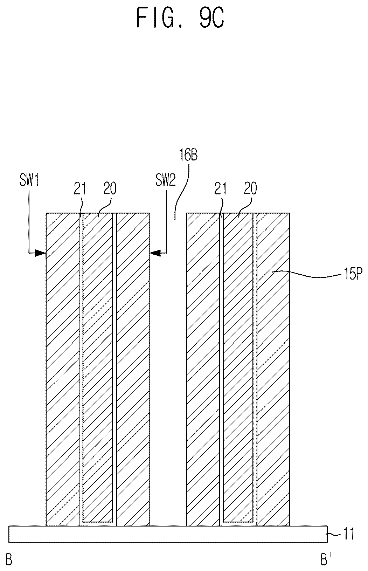

Referring to FIGS. 9A to 9C, a recessed portion 19 may be formed in a portion of the line structures 15L.

The recessed portion 19 may be formed to expose at least a portion of three consecutive sidewalls of the semiconductor pillar 15P. As illustrated in FIG. 9A, the recessed portion 19 may be formed to extend from the exposed first sidewall SW1 or second sidewall SW2 of a semiconductor pillar 15P among the semiconductor pillars 15P and to further expose a portion of the third sidewall SW3 and the fourth sidewall SW4. The recessed portion 19 may be formed by a side recess of a dielectric pillar 14. To form the recessed portion 19, a side recess may be performed from the second segment 16B of the second trench 16. The recessed portion 19 may be formed by performing a patterning process that removes a portion of the dielectric pillar 14. The recessed portion 19 may be formed by etching a portion of the dielectric pillar 14.

The recessed portion 19 may be formed through an etching process using a mask that covers only a portion of a line structure 15L based on the back gate 22. The recessed portion 19 may be formed based on the different etching ratios of the semiconductor pillars 15P and the dielectric pillars 14. The recessed portion 19 may be formed to expose a portion of the third sidewall SW3 and the fourth sidewall SW4 of the semiconductor pillar 15P. During the recessing process of the dielectric pillars 14, the corners of the semiconductor pillars 15P may be rounded.

The recessed portions 19 may be spaced apart from each other in the first direction D1 and may extend parallel to each other in the third direction D3. One recessed portion 19 may be formed in such a manner that the semiconductor pillars 15P disposed adjacent to each other in the first direction D1 face each other symmetrically.

The recessed portions 19 may be formed in such a manner that the neighboring line structures 15L face each other symmetrically. The recessed portions 19 may be formed on the first sidewall SW1 or on the second sidewall SW2 alternately for the line structures 15L that are spaced apart from each other in the first direction D1.

For example, the semiconductor pillars 15P included in a first line structure 15L-1 in the first direction D1 may be formed to extend from the first sidewall SW1 along the third sidewall SW3 and the fourth sidewall SW4. Also, a second line structure 15L-2 disposed adjacent to the first line structure 15L-1 may be formed to extend from the second sidewall SW2, which is a face opposite to the first sidewall SW1, along the third sidewall SW3 and the fourth sidewall SW4. The recessed portion 19 may be formed in such a manner that the neighboring semiconductor pillars 15P that are adjacent to each other on the basis of a line structure face each other symmetrically in the first direction D1. The recessed portion 19 may be integrated with the second segment 16B of the second trench 16.

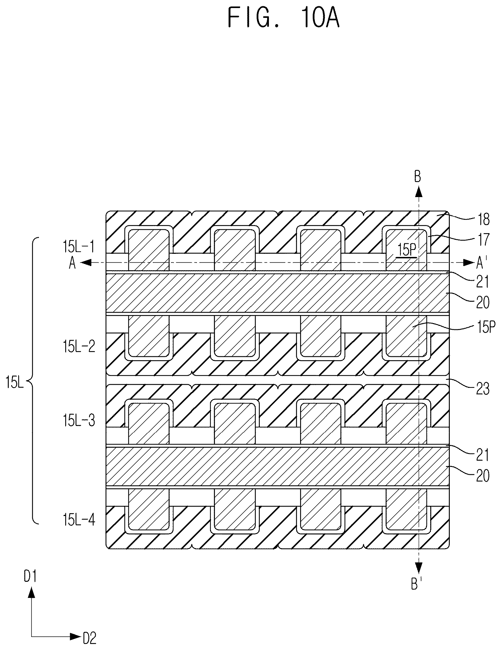

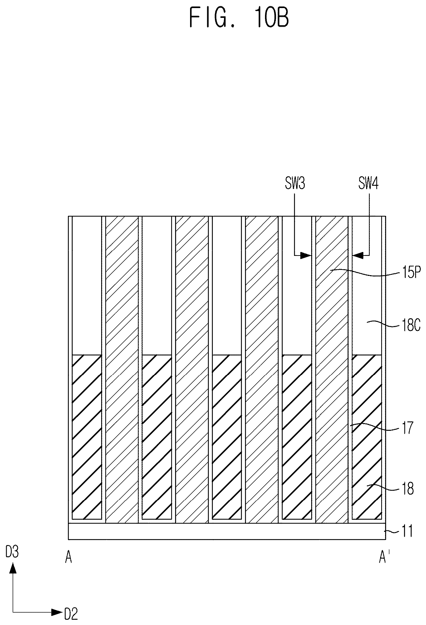

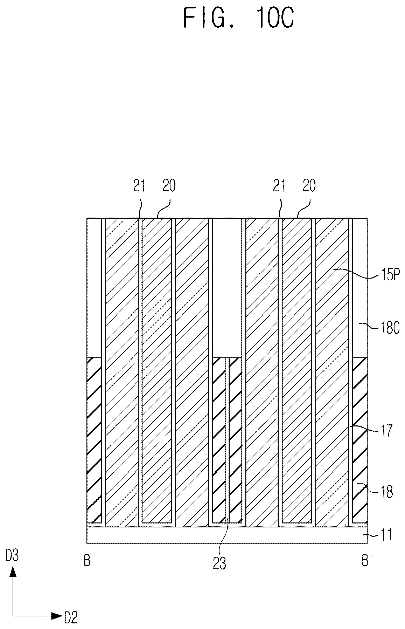

Referring to FIGS. 10A to 10C, a gate dielectric layer 17 may be formed on the exposed first and second sidewalls SW1 and SW2 of the semiconductor pillars 15P. The gate dielectric layer 17 may be formed on a portion of the third and fourth sidewalls SW3 and SW4 exposed by the recessed portion 19. The gate dielectric layer 17 may be formed to surround the sidewalls of the semiconductor pillars 15P that are exposed by the recessed portion 19 and the second trench 16.

The gate dielectric layer 17 may be formed conformally on the first sidewalls SW1 and the second sidewalls SW2 of the semiconductor pillars 15P. The gate dielectric layer 17 may conformally cover the exposed sidewalls and upper surfaces of the semiconductor pillars 15P. The gate dielectric layer 17 may be conformally formed on at least a portion of the third sidewall SW3 and the fourth sidewall SW4 of a semiconductor pillar 15P.

The gate dielectric layer 17 may be planarized to expose the upper surfaces of the semiconductor pillars 15P.

The gate dielectric layer 17 may include silicon oxide, silicon nitride, silicon oxynitride, a high-k material, or a combination thereof. The high-k material may include a material whose dielectric constant is greater than the dielectric constant of silicon oxide. For example, the high-k material may include a material whose dielectric constant is greater than approximately 3.9. The gate dielectric layer 17 may include a metal oxide.

A main gate 18 and a gate capping layer 18C may be formed over the gate dielectric layer 17 of the recessed portion 19. The main gate 18 may be formed by depositing a gate conductive layer and performing an etch-back process. The gate capping layer 18C may be formed over the main gate 18.

The main gate 18 may be formed along the shape of the semiconductor pillars 15P to cover the recessed portion 19 and the sidewalls of the semiconductor pillars 15P that are exposed as the recessed portion 19 is formed.

For example, a gate conductive layer may be formed to fill a portion of the lower portion of the recessed portion 19, and a gate capping layer 18C may be formed to fill the remaining portion of the recessed portion 19. The gate conductive layer may form the main gate 18.

A plurality of main gates 18 may be spaced apart from each other in the first direction D1 and may extend in the second direction D2. The main gates 18 and the back gates 20 may be alternately disposed, and a main gate 18 and a back gate 20 of a pair may be spaced apart from each other in the first direction D1 symmetrically.

The gate capping layer 18C may include silicon nitride.

The main gate 18 may be conformally formed over the gate dielectric layer 17. The main gate 18 may include a metal-based material. The main gate 18 may include a metal, a metal nitride, or a combination thereof. The main gate 18 may include tantalum nitride (TaN), titanium nitride (TiN), tungsten (W), tungsten nitride (WN), titanium, a conductive metal silicide, a conductive metal oxide, or a combination thereof.

A dielectric material 23 may further fill between the main gates 18 that are formed between the semiconductor pillars 15P that are disposed adjacent to each other in the first direction D1.

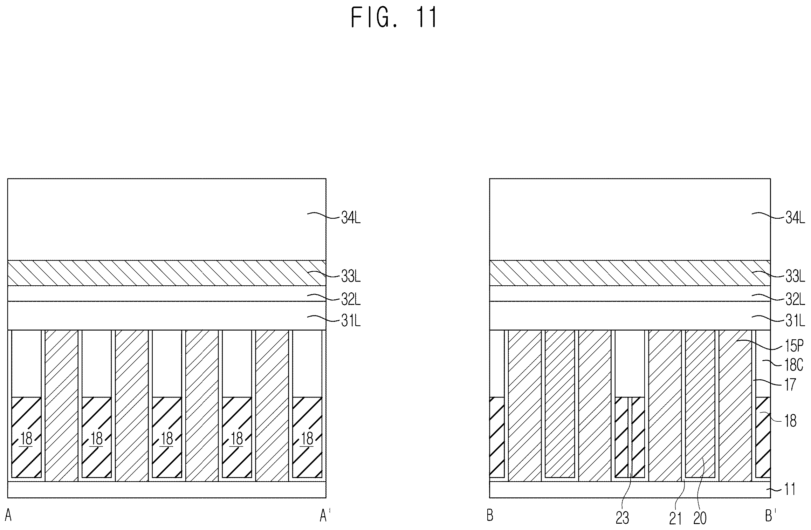

Subsequently, a series of processes as illustrated in FIGS. 11 to 16 may be performed to form a bit line, a shielding layer, an air gap, and an air gap spacer.

FIGS. 11 to 16 are cross-sectional views of the semiconductor device taken along a line A-A' and a line B-B' shown in FIG. 2 which simultaneously illustrate a method for fabricating the semiconductor device.

Referring to FIG. 11, a bit line structure may be formed by sequentially depositing a bit line contact node layer 31L, a bit line barrier layer 32L, a bit line conductive layer 33L, and a bit line hard mask layer 34L.

The bit line contact node layer 31L may include a semiconductor material. For example, the bit line contact node layer 31L may be formed of doped polysilicon.

The bit line barrier layer 32L and the bit line conductive layer 33L may include different types of metal-based materials.

The bit line barrier layer 32L may perform the function of a diffusion barrier. For example, the bit line barrier layer 32L may include a metal, a metal nitride, a metal silicide, or a combination thereof. The bit line barrier layer 32L may include titanium nitride, molybdenum, or ruthenium. The bit line barrier layer 32L may include a titanium nitride layer.

The bit line conductive layer 33L may include a metal-containing material. The bit line conductive layer 33L may include a metal, a metal nitride, a metal silicide, or a combination thereof. Also, the bit line conductive layer 33L may include tungsten (W). The bit line conductive layer 33L may be formed of tungsten (W) or tungsten (W) and tungsten silicide (WSi).

The bit line hard mask layer 34L may be formed of a dielectric material having an etching selectivity with respect to the bit line conductive layer 33L, the bit line barrier layer 32L, and the bit line contact node layer 31L. The bit line hard mask layer 34L may include silicon oxide or silicon nitride. The bit line hard mask layer 34L may be formed of silicon nitride. From the perspective of a top view, the bit line hard mask layer 34L may have a line shape extending in one direction.

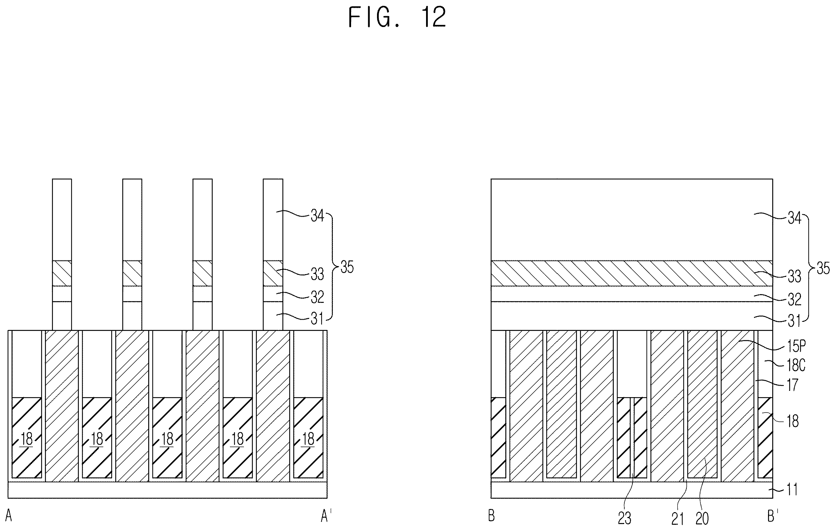

Referring to FIG. 12, the bit line structure 35 may be formed by an etching process using the bit line hard mask layer 34L. The bit line 33, the bit line barrier 32, and the bit line contact node 31 may be etched by using the bit line hard mask layer 34L as an etching barrier.

The bit line 33 may be formed by etching the bit line conductive layer 33L. The bit line barrier 32 may be formed by etching the bit line barrier layer 32L. The bit line contact node 31 may be formed by etching the bit line contact node layer 31L.

The bit line structure 35 may include the bit line contact node 31, the bit line barrier 32, the bit line 33, and the bit line hard mask 34 that are stacked in the mentioned order. From the perspective of a top view, the bit line structure may be a line-shaped pattern structure. From the perspective of a top view, the bit lines 33 may be spaced apart from each other in the second direction D2 and extend in the first direction D1.

Subsequently, an air gap and a shielding layer may be formed between the bit line structures 35.

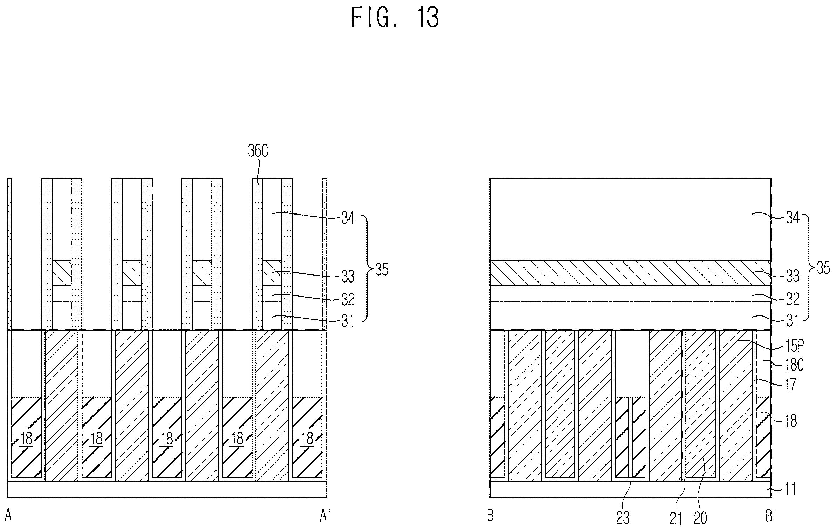

To be specific, as illustrated in FIG. 13, a sacrificial spacer 36C may be formed by depositing a sacrificial material, and then performing a planarization process and an etch-back process sequentially. The sacrificial spacer 36C may be disposed on the sidewall of the bit line structure 35.

The sacrificial spacer 36C may be formed by depositing a sacrificial material and performing an etch-back process. The sacrificial spacer 36C may include a pyrolysis material. The pyrolysis material may be a pyrolytic carbon material. The pyrolytic carbon material may be transformed into gas such as hydrocarbon gas when pyrolyzed.

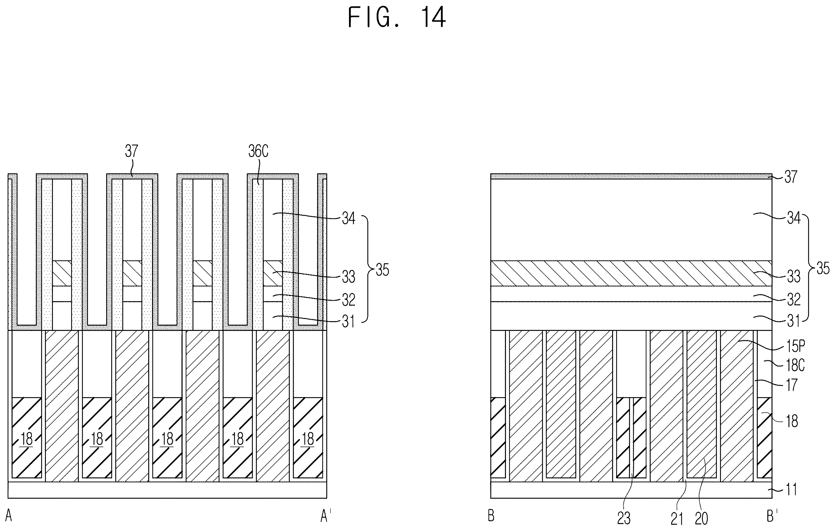

Referring to FIG. 14, an air gap spacer 37 may be formed. The air gap spacer 37 may be formed over the sacrificial spacer 36C. The air gap spacer 37 may cover both sidewalls of the sacrificial spacer 36C and the upper surface of the bit line structure 35.

Since no chemical or plasma is used to form an air-gap space, the air-gap spacer 37 may not be limited to a nitride. According to the embodiment of the present disclosure, the air-gap spacer 37 may include an oxide, silicon carbon oxide (SiCO), boron nitride, or a combination thereof.

The air-gap spacer 37 may have an integrated structure that extends along the bit line structure 35 while covering the sacrificial spacer 36C.

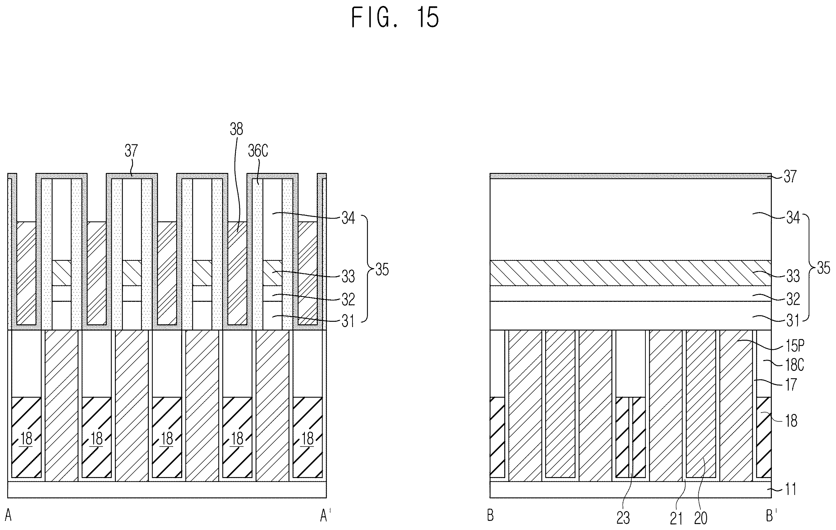

Referring to FIG. 15, a shielding layer 38 may be formed in the space formed by the air-gap spacer 37 between the bit line structures 35. The shielding layer 38 may be formed by depositing a conductive shielding material and then performing a planarization process and an etch-back process sequentially. The shielding layer 38 may be disposed to contact the sidewall of the air gap spacer 37 formed between the bit line structures 35.

The shielding layer 38 may be formed of a conductive shielding material. The conductive shielding material may include an electrically conductive composition. For example, it may be one among diverse metals, such as titanium (Ti), tungsten (W), cobalt (Co), nickel (Ni), platinum (Pt), ruthenium (Ru), and the like. It may also be a composition including one or more among the aforementioned metals, such as a metal silicide, a metal nitride, a metal carbide, and the like. The shielding layer 38 may alleviate or prevent the parasitic capacitance between the neighboring bit lines.

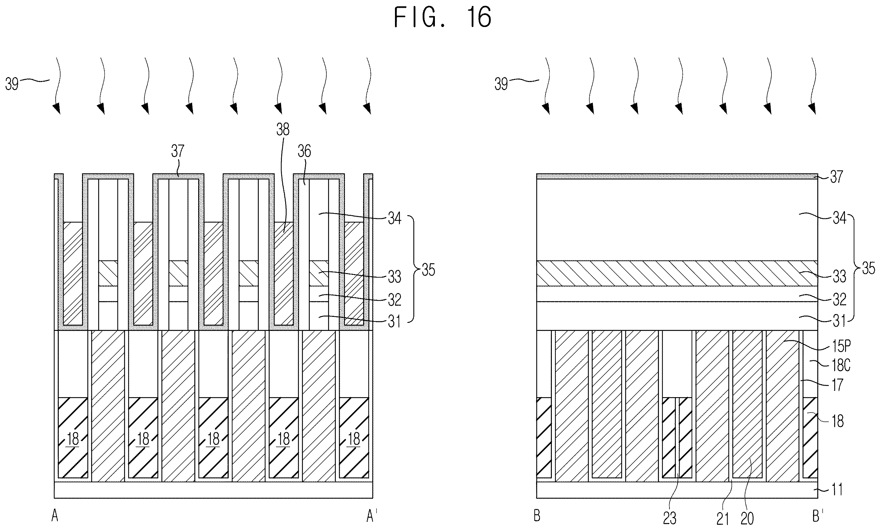

Referring to FIG. 16, the sacrificial spacer 36C may be removed through a thermal process 39. When the sacrificial spacer 36C is removed by heat, an air gap 36 may be formed.

The air gap 36 may be disposed on both sides of the bit line structure 35. The air gap 36 may extend in the first direction D1 parallel to the bit line 33.

The air gap 36 may be disposed between the bit line 33 and the shielding layer 38. The air gap 36 may be formed to have a uniform thickness along the bit line 33. The air gap 36 may extend in the first direction D1 in the same direction that the bit line 33 extends.

The air gap 36 may be formed to have a height which is higher than that of the bit line 33 in the third direction D3. The air gap 36 may be formed to have the same height as that of the bit line structure 35 in the third direction D3.

As a comparative example, the air gap may be omitted in the semiconductor device. In this case, the sensing margin may not be secured due to the parasitic capacitance between the bit lines. The sensing margin may be significantly deteriorated due to the coupling noise that may be caused by the increase in the parasitic capacitance. In the comparative example, a conductor shielding layer may be applied between the bit lines. However, as the physical separation distance becomes closer due to the integration, the parasitic capacitance may increase between the bit line and the shielding layer.

The embodiment of the present disclosure may reduce the parasitic capacitance and secure the sensing margin by applying the air gap structure.

Also, in order to perform a series of processes of removing the sacrificial material for forming an air gap and blocking the upper portion in the comparative example, it is required to secure the space. Therefore, there may be difficulties in reducing the space for forming an air gap. The method for forming an air gap in a fine pattern may have increased process difficulty and limitation in dimensions, which makes it difficult to apply the method to a vertical gate.

This embodiment of the present disclosure may reduce the process difficulty by using a pyrolytic carbon layer as a sacrificial spacer and forming an air gap between the bit line and the shielding layer. The difficulty of an air gap material removal process may be reduced by using the pyrolytic carbon layer.

By using a sacrificial spacer 36C to form the air gap 36, it is possible to overcome the spatial constraints in the process of forming the air gap. By forming the air gap between the bit line and the shielding layer by using a pyrolytic carbon layer, the spatial constraints may be overcome.

As another comparative example, a pin-hole may be formed in the air gap spacer by removing a material for forming an air gap during a wet cleaning process WET CLN using a chemical or a dry cleaning process DRY CLN using plasma in a narrow space. The process for removing the material for forming the air gap in the narrow space may be performed during the wet cleaning process or the dry cleaning process. In this process, the air gap spacer may be required to have a minimum thickness to prevent the pin hole phenomenon.

According to this embodiment of the present disclosure, an air gap may be formed by using a pyrolytic carbon material without performing a series of processes of blocking the upper portion to remove the sacrificial material for forming the air gap. In other words, it may not have to perform a wet cleaning process or a dry cleaning process to remove the sacrificial material.

Accordingly, the bit line and the shielding layer may be protected from the chemical or the plasma entering through the pin hole of the air gap spacer, thereby reducing the influence on the structure and characteristics. In other words, since the pyrolytic carbon material is used, it may not have to prevent the pin hole phenomenon. Therefore, the thickness of the air gap spacer may be decreased. This may allow more air gap space and reduce unnecessary parasitic capacitance.

Also, since the chemical or the plasma has to be used to form the air gap in the comparative example, nitride may be restrictively used for the air gap spacer.

According to this embodiment of the present disclosure, by forming the air gap of a pyrolytic carbon material, an oxide, silicon carbon oxide (SiCO), boron nitride (BN), or a combination thereof may be applied as the air gap spacer 37. As for the air gap spacer 37, a variety of material candidates may be applied, such as silicon oxide (SiO₂), silicon carbon oxide (SiCO), silicon nitride (Si₃N₄), silicon oxynitride (SiON) and the like.

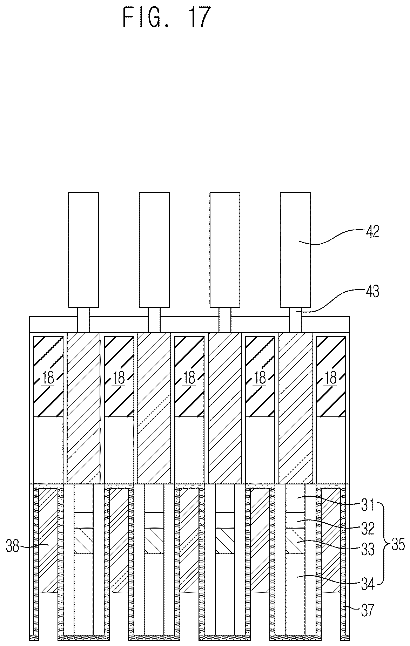

FIG. 17 illustrates a semiconductor device in accordance with another embodiment of the present disclosure.

Referring to FIG. 17, the semiconductor may include a bit line 35, a semiconductor pillar 15 extending vertically from the bit line 35, and a memory element 42 and a memory element contact element 43 over the semiconductor pillar 15. The bit line structure 35 may include the bit line contact node 31, the bit line barrier 32, the bit line 33, and the bit line hard mask 34 that are stacked in the mentioned order. A shielding layer 38 may be formed between the bit line structures 35.

The memory element 42 may include a capacitor.

Referring to FIG. 17, the semiconductor device may have one side of the semiconductor pillar 15 in a direction that the semiconductor pillar 15 extends coupled to the bit line 35, and another side of the semiconductor pillar 15 in the direction that the semiconductor pillar 15 extends coupled to the memory element contact element 43.

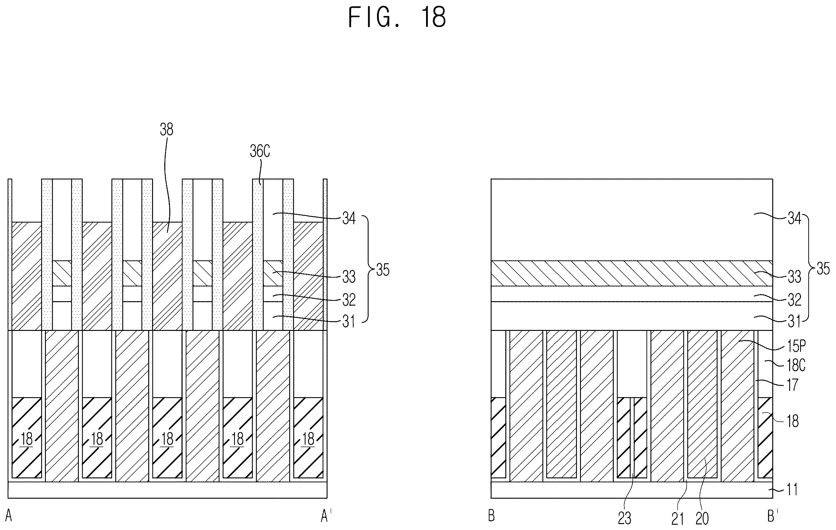

FIGS. 18 to 20 illustrate an example of a method for fabricating a semiconductor device in accordance with another embodiment of the present disclosure.

The semiconductor devices shown in FIGS. 18 to 20 are cross-sectional views illustrating a method for fabricating a semiconductor device taken along a line A-A' and a line B-B' shown in FIG. 2 in accordance with another embodiment of the present disclosure.

The semiconductor device may be similar to the semiconductor device illustrated in FIGS. 5A to 12. Hereinafter, as for the description on the semiconductor device illustrated in FIGS. 18 to 20, detailed description on the constituent elements also appearing in FIGS. 5A to 12 may be referred to.

Referring to FIG. 18, a sacrificial material may be deposited on the upper surface and sidewall of the bit line structure 35 to form a sacrificial spacer 36C. Subsequently, the sacrificial spacer 36C may be formed by depositing the sacrificial material and then performing a planarization process and an etch-back process. The sacrificial material may be a pyrolytic sacrificial material. The sacrificial material may be a pyrolytic carbon material. The pyrolytic carbon material may be transformed into gas, such as hydrocarbon gas when pyrolyzed.

A shielding layer 38 may be formed by depositing a conductive shielding material in a space where the sacrificial spacer 36C is formed between the bit line structures 35 and then performing a planarization process and an etch-back process sequentially. The shielding layer 38 may be formed to contact a portion of the sacrificial spacer 36C that is formed between the bit line structures 35.

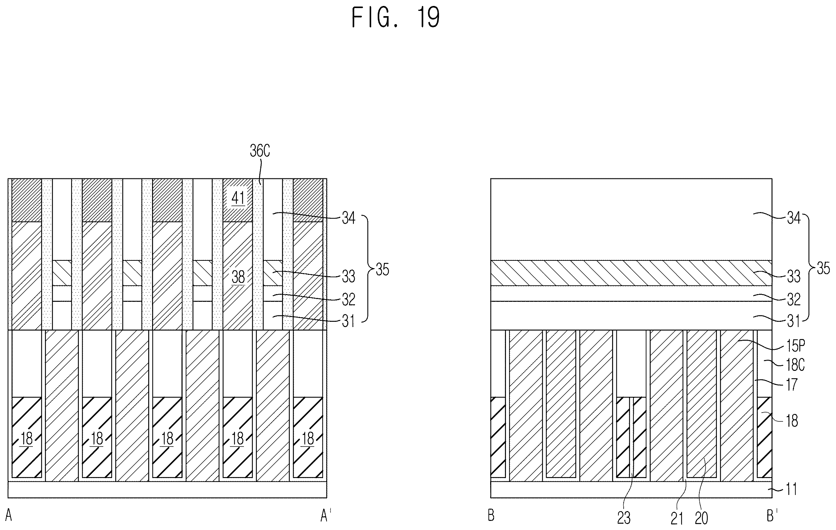

Referring to FIG. 19, a shield capping layer 41 may be formed in the upper portion of the shielding layer 38. The shield capping layer 41 may be formed by depositing a conductive material to have the same height as that of the bit line structure 35 and then performing a planarization process and an etch-back process.

The shield capping layer 41 may include a metal-based material. The shield capping layer 41 may include a metal, a metal nitride, a metal silicide, or a combination thereof. The shield capping layer 41 may be a tungsten layer that is deposited by a Physical Vapor Deposition (PVD) process.

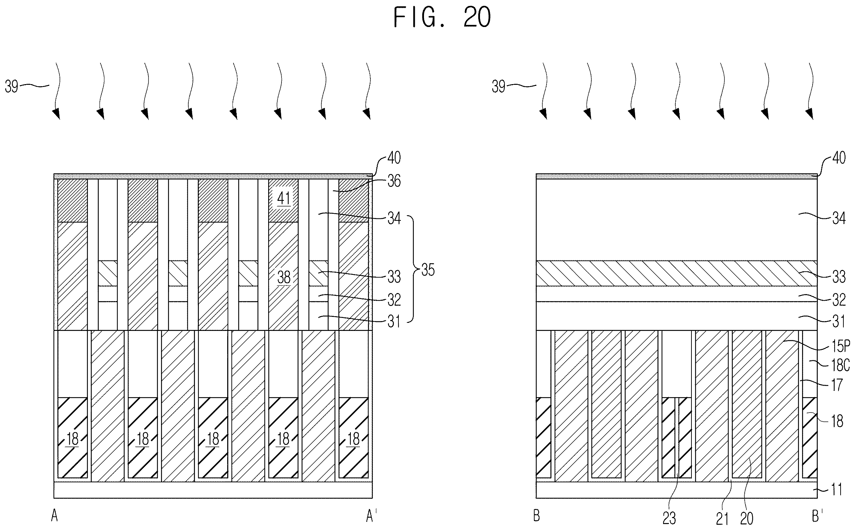

Referring to FIG. 20, the sacrificial spacer 36C may be removed through a thermal process 39. When the sacrificial spacer 36C is removed by heat, an air gap 36 may be formed.

Subsequently, an air gap capping layer 40 may be formed on the upper surfaces of the bit line structure 35 and the shield capping layer 41. The air gap capping layer 40 may be deposited on the upper surfaces of the shield capping layer 41 and the bit line structure 35. The air gap 36 may be formed by the air gap capping layer 40.

The air gap capping layer 40 may include a dielectric material. The air gap capping layer 40 may include silicon nitride, silicon oxynitride, or a combination thereof.

According to the present technology, when a shielding layer is applied between the bit lines, a capacitance reducing effect between the bit lines may be derived.

When a shielding layer formed of a conductive material is applied between the bit lines, it may be found out as a result of the simulation that the capacitance between the bit lines BL-BL Cap may decrease to approximately a fifth (1/5) or lower whereas the total capacitance between the bit lines BL Total Cap increases approximately two times.

In other words, by applying a shielding layer between the bit lines, the ratio (portion) of the capacitance between the bit lines BL-BL Cap to the total capacitance between the bit lines BL Total Cap may be reduced significantly.

Also, when a shielding layer is applied between the bit lines, the generated voltage Del-V between the bit lines may be reduced. The simulation result of the noise values between the bit lines depending on whether a shielding layer is applied between the bit lines shows that the relative sensing margin value is decreased when the shielding layer is applied.

According to the embodiment of the present disclosure, it is possible to reduce the coupling noise that may be caused by the mutual interference between the neighboring bit lines by forming a shielding layer between the bit lines.

According to the embodiment of the present disclosure, the parasitic capacitance between the neighboring bit lines may be reduced by forming an air gap and a shielding layer between the bit lines.

According to the embodiment of the present disclosure, the electrical characteristics of a semiconductor device may be improved by securing a sensing margin of the semiconductor device.

While the present disclosure has been described with respect to the specific embodiments, it will be apparent to those skilled in the art that various changes and modifications may be made without departing from the spirit and scope of the invention as defined in the following claims.

## Claims

1. A method for fabricating a semiconductor device, the method comprising:
forming a semiconductor pillar;
forming a bit line over the semiconductor pillar;
forming a sacrificial spacer on a sidewall of the bit line;
forming a shielding layer disposed on the sacrificial spacer; and
forming an air gap between the shielding layer and the bit lines by removing the sacrificial spacer.

2. The method of claim **1,** wherein the sacrificial spacer contains a pyrolytic sacrificial material.

3. The method of claim 2, wherein the pyrolytic sacrificial material includes a pyrolytic carbon material.

4. The method of claim 1, wherein forming the air gap comprises performing a thermal process to remove the sacrificial spacer by heat.

5. The method of claim 1, wherein forming the sacrificial spacer comprises:
depositing a sacrificial material; and
performing an etch-back process on the sacrificial material.

6. The method of claim 1, further comprising, after forming of the semiconductor pillar:
forming a back gate on a sidewall of the semiconductor pillar; and
forming a main gate to surround at least a portion of three adjacent sidewalls of the semiconductor pillar, excluding the first sidewall where the back gate is formed.

7. The method of claim 6,
Wherein forming the main gate comprises:
forming a recessed portion to expose at least the portion of the three consecutive sidewalls of the semiconductor pillars;
forming a gate dielectric layer conformally on the sidewall of the semiconductor pillars exposed by the recessed portion; and
forming a gate conductive layer over the gate dielectric layer.

8. The method of claim 1, further comprising, after forming the shielding layers, forming a shield capping layer over the shielding layer.

9. The method of claim 8, further comprising, after forming the shield capping layers, forming an air gap capping layer over the bit line and the shield capping layer.

10. The method of claim 1, further comprising, before forming the shielding layer, forming an air gap spacer over the sacrificial spacer.

11. A semiconductor device comprising:
a plurality of semiconductor pillars;
main gates respectively disposed to cover one sidewall of each of the plurality of semiconductor pillars;
bit lines respectively coupled to the plurality of semiconductor pillars;
shielding layers disposed between the bit lines; and
air gaps disposed between the shielding layers and the bit lines.

12. The semiconductor device of claim 11, wherein the bit lines and the shielding layers extend in a first direction, and the plurality of semiconductor pillars extend along a second direction perpendicular to the first direction.

13. The semiconductor device of claim 11, wherein the shielding layers have a height higher than a height of the bit lines.

14. The semiconductor device of claim 11, wherein the shielding layers contain a conductive shielding material.

15. The semiconductor device of claim 11, wherein the air gaps extend in a same direction that the bit lines extend.

16. The semiconductor device of claim 11, wherein the air gap has a height higher than a height of the bit lines.

17. The semiconductor device of claim 11, further comprising a back gate disposed between the plurality of semiconductor pillars.

18. The semiconductor device of claim 11, further comprising air gap spacers disposed between the shielding layers and the air gaps to surround each of the air gaps on both sides of each of the bit lines.

19. The semiconductor device of claim 18, wherein the air gap spacers contain one among oxide, silicon carbon oxide (SiCO), and boron nitride (BN).
